# FASCICULE DE BREVET EUROPEEN

(11) **EP 3 725 136 B1**
(45) Date de publication et mention de la délivrance du brevet: **05.07.2023**
(21) Numéro de dépôt: 18799560.0
(22) Date de dépôt: 14.11.2018
(51) Int. Cl.: H05K 1/02, H05K 7/14

(54) **DISPOSITIF AVEC SUPPORT DE CONFORMATION D'UNE PORTION FLEXIBLE D'UN CIRCUIT IMPRIME FLEXIBLE**
GERÄT MIT TRÄGER ZUM FORMEN EINES FLEXIBLEN ABSCHNITTS EINER FLEXIBLEN LEITERPLATTE
DEVICE WITH SUPPORT FOR SHAPING A FLEXIBLE PORTION OF A FLEXIBLE PRINTED CIRCUIT BOARD

(30) Priorité: 15.12.2017 FR 1762292
(43) Date de publication de la demande: 21.10.2020
(73) Titulaire: SAGEMCOM BROADBAND SAS, 92500 Rueil-Malmaison (FR)
(72) Inventeur: MAURECH, Cécile, 92500 RUEIL MALMAISON (FR); LE HENANFF, Yann, 92500 RUEIL MALMAISON (FR)
(74) Mandataire: Lavaud, Thomas
(86) Numéro de dépôt international: PCT/EP2018/081233
(87) Numéro de publication internationale: WO 2019/115123

(56) Documents cités:
- JP-A- 2001 355 664
- JP-A- 2011 181 621
- US-A1- 2015 282 304

## Description

L'invention concerne le domaine des supports de conformation d'une portion flexible d'un circuit imprimé flexible.

### ARRIERE PLAN DE L'INVENTION

De nombreux équipements électriques comprennent un ou plusieurs circuits imprimés dits « souples » ou « flexibles ».

Un circuit imprimé flexible représente une solution particulièrement intéressante pour réaliser des connexions électriques entre deux parties d'un même équipement électrique mobiles ou orientées l'une par rapport à l'autre, pour intégrer des fonctions électroniques dans un équipement électrique susceptible d'être tordu ou plié, ou bien pour optimiser une intégration de fonctions électroniques dans un volume restreint.

Il a ainsi été envisagé de fixer un circuit imprimé flexible sur un dissipateur thermique de type dissipateur thermique à ailettes. Le circuit imprimé flexible et le dissipateur thermique sont ensuite intégrés dans un équipement électrique, par exemple dans une passerelle résidentielle en forme de « tour ».

Le circuit imprimé flexible comprend une première portion, une deuxième portion et une portion flexible réalisant la jonction entre la première portion et la deuxième portion. La première portion est positionnée contre une première face latérale du dissipateur thermique. La deuxième portion est positionnée contre une deuxième face latérale du dissipateur thermique. La première face latérale et la deuxième face latérale sont adjacentes. La portion flexible s'étend alors autour d'un coin externe du dissipateur thermique défini par la jonction de la première face latérale et de la deuxième face latérale.

On optimise ainsi l'intégration du circuit imprimé flexible et du dissipateur thermique dans l'équipement électrique.

Pour mettre en œuvre une telle application, il a été envisagé d'utiliser un circuit imprimé flexible fabriqué selon une technologie dite « flex », ou bien selon une technologie dite « flex-rigide », ou bien encore selon une technologie dérivée de ces technologies. Dans la technologie « flex », le substrat de l'ensemble du circuit imprimé flexible est fabriqué en un matériau souple, par exemple en PEEK ou en polyester. Dans la technologie « flex-rigide », seule une portion du circuit imprimé flexible est flexible.

Dans les deux cas, on utilise un matériau très souple qui adopte de lui-même, pendant son intégration, la courbure définie par sa position sur le dissipateur thermique.

Deux obstacles principaux s'opposent à l'utilisation de cette solution.

Un premier obstacle concerne le coût de la solution. Les technologies dites « flex » ou « flex-rigide » sont des technologies très onéreuses.

Un deuxième obstacle concerne la proximité entre la portion flexible du circuit imprimé flexible et les masses métalliques du dissipateur thermique. Des signaux électriques à haute fréquence sont susceptibles de circuler dans la portion flexible. Le routage de ces signaux électriques doit faire l'objet d'une attention particulière. En particulier, l'impédance caractéristique des pistes sur lesquelles ces signaux électriques circulent doit être parfaitement maîtrisée. Or, cette impédance caractéristique dépend fortement des masses métalliques situées à proximité de la portion flexible (jusqu'à une distance de quelques millimètres). Il est impossible de protéger ces signaux électriques au niveau de la portion flexible elle-même, car la portion flexible comporte moins de couches de routage que la première portion et la deuxième portion.

Il convient donc de garantir un éloignement suffisant et maîtrisé entre la portion flexible et le dissipateur thermique, ce qui est complexe à assurer.

On a envisagé, pour surmonter ces obstacles, de former le circuit imprimé directement sur le dissipateur thermique. Cependant, la méthode de fabrication habituelle des dissipateurs thermiques, par injection d'aluminium, n'offre pas des tolérances de fabrication compatibles avec la précision requise pour conformer la partie flexible d'un circuit imprimé.

JP 2011 181621 A divulgue un dispositif comprenant un circuit imprimé flexible et un socle, le circuit imprimé flexible comprenant une première portion fixée à une première face latérale du socle, une deuxième portion fixée à une deuxième face latérale du socle, et la portion flexible qui s'étend autour du coin externe du socle.

### OBJET DE L'INVENTION

L'invention a pour objet d'intégrer un circuit imprimé flexible sur un dissipateur thermique, en surmontant les obstacles qui viennent d'être évoqués.

### RESUME DE L'INVENTION

En vue de la réalisation de ce but, on propose un dispositif comme revendiqué dans la revendication 1.

Grâce au support de conformation dans le dispositif selon l'invention, on assure un éloignement minimal, par exemple égal à au moins 1mm, entre le circuit imprimé flexible et le dissipateur thermique. On assure aussi que la portion flexible du circuit imprimé flexible est parfaitement enroulée autour de la portion angulaire de cylindre de la première surface d'appui. Ainsi, la portion flexible n'est ni stressée ni fragilisée lorsque le circuit imprimé flexible est fixé sur le dissipateur thermique.

Il est donc possible d'utiliser un circuit imprimé flexible utilisant une solution moins onéreuse qu'une solution de type « flex » ou « flex rigide », et par exemple un circuit imprimé flexible dont la portion flexible est rendue flexible par un usinage local consistant à couper ou à presser des zones de la portion flexible.

On propose de plus un équipement électrique comprenant un boîtier à l'intérieur duquel est intégré un dispositif tel que celui qui vient d'être décrit.

D'autres caractéristiques et avantages de l'invention ressortiront à la lecture de la description qui suit de modes de réalisation particuliers non limitatifs de l'invention.

### BREVE DESCRIPTION DES DESSINS

Il sera fait référence aux dessins annexés, parmi lesquels :
- la figure 1 représente un circuit imprimé flexible, un dissipateur thermique, et un support de conformation selon un premier mode de réalisation de l'invention ;
- la figure 2 représente le principe du pliage du circuit imprimé flexible ;
- la figure 3 représente un circuit imprimé flexible, un dissipateur thermique, et un support de conformation selon un deuxième mode de réalisation de l'invention ;
- la figure 4 représente un circuit imprimé flexible, un dissipateur thermique, et un support de conformation selon un troisième mode de réalisation de l'invention ;
- la figure 5 représente un circuit imprimé flexible, un dissipateur thermique, et un support de conformation fixé au circuit imprimé.

### DESCRIPTION DETAILLEE DE L'INVENTION

L'invention est ici mise en oeuvre dans une passerelle résidentielle en forme de « tour ».

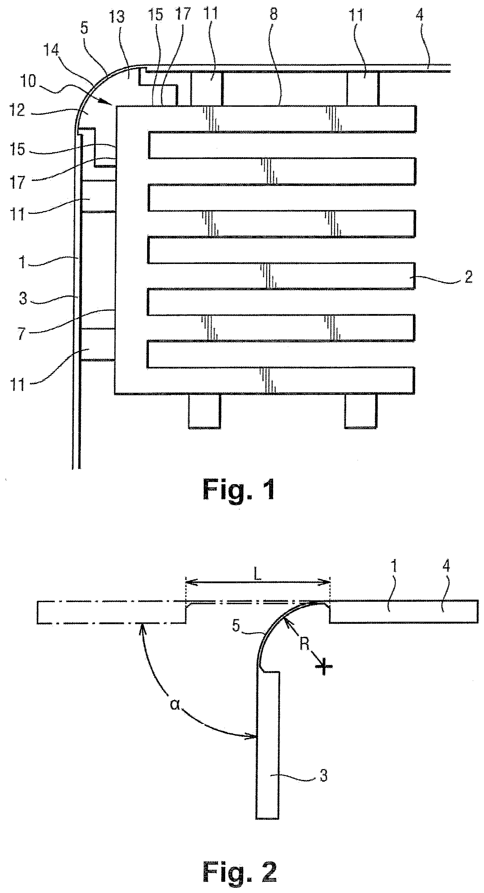

En référence à la figure 1, on fixe un circuit imprimé flexible 1 sur un dissipateur thermique 2, pour des raisons d'intégration qui ont été évoquées plus tôt. Le circuit imprimé flexible 1 et le dissipateur thermique 2 sont ensuite intégrés dans un boîtier de la passerelle résidentielle.

Le dissipateur thermique 2 est utilisé pour dissiper une chaleur produite par des composants électriques montés sur le circuit imprimé flexible 1.

Le circuit imprimé flexible 1 comprend un substrat en fibre de verre.

Le circuit imprimé flexible 1 comporte une première portion de circuit imprimé flexible 3, une deuxième portion de circuit imprimé flexible 4, et une portion flexible 5.

La première portion 3 et la deuxième portion 4 sont ici des portions rigides. La portion flexible 5 est rendue flexible par un usinage local consistant à couper ou à presser des zones de la portion flexible 5. Cet usinage local est réalisé au moment de la fabrication du circuit imprimé flexible 1, préalablement à sa fixation sur le dissipateur thermique 2.

La portion flexible 5 réalise une jonction entre la première portion 3 et la deuxième portion 4.

La portion flexible 5 est une portion comprenant au moins une couche de signaux électriques associée à un substrat. La portion flexible 5 comprend en l'occurrence ici deux couches de signaux électriques associées aux substrats correspondants.

Lors de la fabrication du circuit imprimé flexible 1, on vient presser des couches supplémentaires, en l'occurrence deux couches supplémentaires, sur la première portion 3 et sur la deuxième portion 4. Les deux couches supplémentaires sont ici deux couches de signaux électriques. La première portion 3 et la deuxième portion 4 comportent donc ici quatre couches.

On note que la portion flexible 5 pourrait aussi être obtenue en usinant localement au moins une couche de signaux électriques et les substrats correspondants, pour permettre une souplesse par rapport au circuit imprimé rigide initial utilisé pour fabriquer le circuit imprimé flexible 1.

Le dissipateur thermique 2 est un dissipateur thermique à ailettes. Le dissipateur thermique 2 comporte une première face latérale 7 et une deuxième face latérale 8 perpendiculaire à la première face latérale 7. Un coin externe 10 du dissipateur thermique 2 est défini à l'intersection de la première face latérale 7 et de la deuxième face latérale 8. On précise que la première face latérale 7 et la deuxième face latérale 8 pourraient parfaitement ne pas être perpendiculaires entre elles, mais être orientées l'une par rapport à l'autre d'un angle quelconque.

Des excroissances métalliques, formant des plots 11, s'étendent depuis la première face latérale 7 et la deuxième face latérale 8.

La première portion 3 du circuit imprimé flexible 1 doit être fixée sur les plots 11 de la première face latérale 7. La deuxième portion 4 du circuit imprimé flexible 1 doit être fixée sur les plots 11 de la deuxième face latérale 8.

La première portion 3 et la deuxième portion 4 pourraient être fixées à la première face latérale 7 et à la deuxième face latérale 8 avec tout type de moyens de fixation, et notamment avec des moyens de fixation autres que des excroissances, et avec des moyens de fixation métalliques ou non. Des colonnettes en plastique peuvent par exemple être utilisées.

En référence à la figure 2, au moment de sa fixation sur le dissipateur thermique 2, le circuit imprimé flexible 1 est plié au niveau de la portion flexible 5 sur une longueur L, d'un angle de pliage α, pour obtenir un rayon de courbure R. Le pliage est permis et facilité par l'usinage local du circuit imprimé flexible 1.

Pour fixer le circuit imprimé flexible 1 au dissipateur thermique 2, on utilise un support de conformation selon un premier mode de réalisation de l'invention 12.

Le support de conformation 12 comprend un corps 13 ayant au moins une première surface d'appui et au moins une deuxième surface d'appui. La ou les premières surfaces d'appui sont situées au niveau d'un premier côté du corps 13, alors que la ou les deuxièmes surfaces d'appui sont situées au niveau d'un deuxième côté du corps 13, le deuxième côté étant situé à l'opposé du premier côté.

Le corps 13 comporte ici en l'occurrence une seule première surface d'appui 14 et deux deuxièmes surfaces d'appui 15.

La première surface d'appui 14 a la forme d'une portion angulaire de cylindre. Les deux deuxièmes surfaces d'appui 15 sont planes et perpendiculaires entre elles.

Le corps 13 du support de conformation 12 est ici fabriqué en une matière rigide, non conductrice, par exemple en une matière thermoplastique ou en céramique, ou en toute autre matière non conductrice.

Le corps 13 est fabriqué avec une première tolérance de fabrication inférieure à un premier seuil de tolérance prédéterminé. Le premier seuil de tolérance prédéterminé est ici égal à 0,3mm. Le corps 13 présente donc une tolérance de forme très précise. Le premier seuil de tolérance prédéterminé pourrait être différent. Le premier seuil de tolérance prédéterminé est défini en fonction de la tolérance admise par le circuit imprimé flexible 1 pour éviter sa détérioration.

Les deux deuxièmes surfaces d'appui 15 du corps 13 du support de conformation 12 sont destinées à venir en appui contre deux surfaces complémentaires 17 du dissipateur thermique 2. Les deux surfaces complémentaires 17 sont planes et perpendiculaires entre elles. Les deux surfaces complémentaires 17 sont des portions de la première face latérale 7 et de la deuxième face latérale 8 du dissipateur thermique 2. Les deux surfaces complémentaires 17 se rejoignent pour former le coin externe 10 du dissipateur thermique 2.

On note que les deux deuxièmes surfaces d'appui 15 ne sont pas nécessairement planes, ni perpendiculaires entre elles. Les deux deuxièmes surfaces d'appui 15 sont prévues pour venir se positionner sur les deux surfaces complémentaires 17 du dissipateur thermique 2, qui ne sont pas nécessairement planes et perpendiculaires entre elles. Ainsi, les deux deuxièmes surfaces d'appui 15 sont planes et perpendiculaires entre elles seulement si les deux surfaces complémentaires 17 du dissipateur thermique 2 le sont aussi.

Le dissipateur thermique 2 est usiné de manière très précise au niveau des deux surfaces complémentaires 17, de sorte que les deux surfaces complémentaires 17 sont fabriquées avec une deuxième tolérance de fabrication inférieure à un deuxième seuil de tolérance prédéterminé. Le deuxième seuil de tolérance prédéterminé est ici égal à 0,1mm. Le dissipateur thermique 2, au niveau du coin externe 10, présente donc une tolérance de forme très précise. Le deuxième seuil de tolérance prédéterminé pourrait être différent. Le deuxième seuil de tolérance prédéterminé est défini de sorte que la somme des tolérances, c'est-à-dire la somme du premier seuil de tolérance prédéterminé et du deuxième seuil de tolérance prédéterminé, permette de garantir l'intégrité du circuit imprimé flexible 1.

Ainsi, au moment de la fixation du circuit imprimé flexible 1 sur le dissipateur thermique 2, le support de conformation 12 est tout d'abord fixé au coin externe 10 du dissipateur thermique 2 grâce à des moyens de fixation quelconques : vis, bouterollage, colle, encliquetage, etc.

Puis, la première portion rigide 3 du circuit imprimé flexible 1 est fixée sur les plots 11 de la première face latérale 7 du dissipateur thermique 2.

La portion flexible 5 est ensuite conformée autour de la première surface d'appui 14 en forme de portion angulaire de cylindre du corps 13 du support de conformation 12.

La deuxième portion 4 du circuit imprimé flexible 1 est alors fixée sur les plots 11 de la deuxième face latérale 8 du dissipateur thermique 2.

La première tolérance de fabrication du corps 13 du support de conformation 12 et la deuxième tolérance de fabrication des surfaces complémentaires 17 du coin externe 10 du dissipateur thermique 2 permettent d'assurer que la portion flexible 5 vient en appui sur l'ensemble de la première surface d'appui 14 du corps 13. La première tolérance de fabrication et la deuxième tolérance de fabrication permettent aussi d'assurer que l'ensemble des deuxièmes surfaces d'appui 15 du corps 13 du support de conformation 12 viennent en appui contre les surfaces complémentaires 17. En particulier, le coin externe 10 du dissipateur thermique 2 est parfaitement emboîté dans un coin interne du support de conformation 12 situé à l'intersection des deux deuxièmes surfaces d'appui 15.

On garantit ainsi une conformation précise qui assure que la portion flexible 5 du circuit imprimé flexible 1 adopte une forme parfaitement cylindrique. On assure aussi un éloignement d'au moins 1mm entre le dissipateur thermique 2 et chaque point de la portion flexible 5 par lequel passe un signal électrique à haute fréquence (ou tout autre signal électrique sensible). Les signaux électriques à haute fréquence ne sont donc pas perturbés par les parties métalliques du dissipateur thermique 2.

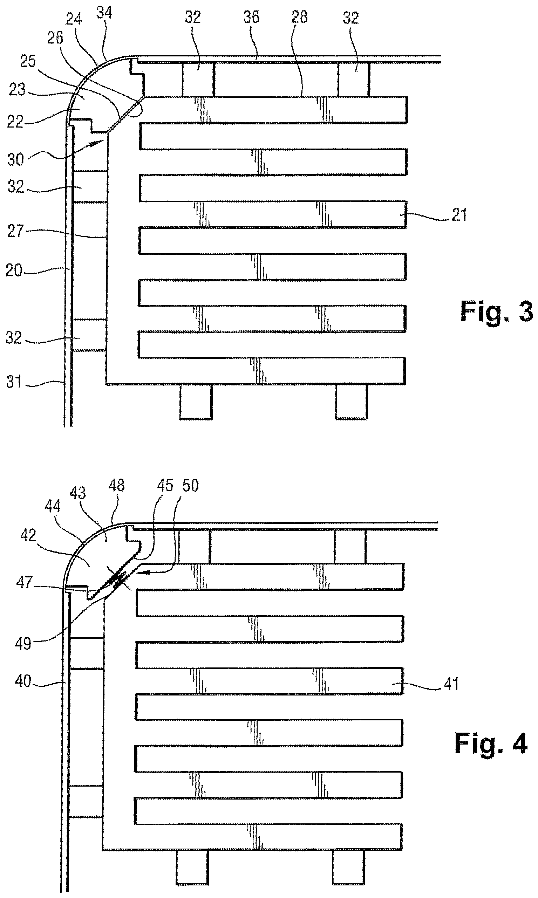

En référence à la figure 3, pour fixer le circuit imprimé flexible 20 sur le dissipateur thermique 21, on utilise alternativement un support de conformation selon un deuxième mode de réalisation de l'invention 22.

Le support de conformation 22 comprend un corps 23 ayant une première surface d'appui 24 et une deuxième surface d'appui 25. La première surface d'appui 24 et la deuxième surface d'appui 25 sont à nouveau situées sur deux côtés opposés du support de conformation 22.

La première surface d'appui 24 a la forme d'une portion angulaire de cylindre. La deuxième surface d'appui 25 est plane.

Le corps 23 du support de conformation 22 est ici fabriqué en une matière élastique, non conductrice, par exemple en silicone ou en caoutchouc. La dureté de la matière est ajustée en fonction de l'épaisseur du corps 23. Pour évaluer la dureté, on peut utiliser une échelle de Shore, ou tout autre type d'échelle. Sur l'échelle de dureté de Shore, on choisira une dureté comprise entre 40 et 60 Shore A et, avantageusement, proche ou égale à 50 Shore A.

La deuxième surface d'appui 25 du corps 23 du support de conformation 22 est destinée à venir en appui contre une surface complémentaire 26 du dissipateur thermique 21.

La surface complémentaire 26 est une surface plane faisant la jonction entre la première face latérale 27 et la deuxième face latérale 28. La surface complémentaire 26 est orientée d'un angle de 45° par rapport à la première face latérale 27 et par rapport à la deuxième face latérale 28. La surface complémentaire 26, la première face latérale 27 et la deuxième face latérale 28 forment un angle cassé (ou chanfrein) au niveau du coin externe 30.

Le dissipateur thermique 21, et, notamment, le coin externe 30 et la surface complémentaire 26, sont fabriqués avec une tolérance de fabrication large, ici supérieure à 1mm.

Ainsi, au moment de la fixation du circuit imprimé flexible 20 sur le dissipateur thermique 21, le support de conformation 22 est tout d'abord fixé au coin externe 30 du dissipateur thermique 21 grâce à des moyens de fixation quelconques : vis, bouterollage, colle, encliquetage, etc.

Puis, la première portion 31 du circuit imprimé flexible 20 est fixée sur les plots 32 de la première face latérale 27 du dissipateur thermique 21.

La portion flexible 34 est ensuite conformée autour de la première surface d'appui 24 du corps 23 du support de conformation 22.

La deuxième portion 36 du circuit imprimé flexible 20 est alors fixée sur les plots 32 de la deuxième face latérale 28 du dissipateur thermique 21.

Le support de conformation 22, dont le corps 23 est élastique, permet d'assurer le contre appui et de compenser la tolérance de fabrication large du dissipateur thermique 21 et donc les tolérances de forme.

On garantit ainsi à nouveau une conformation précise de la portion flexible 34 qui adopte une forme cylindrique. On assure à nouveau un éloignement d'au moins 1mm entre le dissipateur thermique 21 et chaque point de la portion flexible 34 par lequel passe un signal électrique à haute fréquence (ou tout autre signal électrique sensible).

En référence à la figure 4, pour fixer le circuit imprimé flexible 40 au dissipateur thermique 41, on utilise alternativement un support de conformation selon un troisième mode de réalisation de l'invention 42.

Le support de conformation 42 comprend un corps 43 dont la forme est proche de la forme du corps 23 du support de conformation selon le deuxième mode de réalisation de l'invention 22.

Le corps 43 présente donc une première surface d'appui 44 et une deuxième surface d'appui 45. La première surface d'appui 44 et la deuxième surface d'appui 45 sont à nouveau situées sur deux côtés opposés du support de conformation 42. La première surface d'appui 44 a la forme d'une portion angulaire de cylindre. La deuxième surface d'appui 45 est plane.

Le corps 43 du support de conformation 42 est ici fabriqué en une matière rigide, non conductrice, par exemple en une matière thermoplastique, en céramique, ou en toute autre matière non conductrice.

Le corps 43 est fabriqué avec une troisième tolérance de fabrication qui est relativement large, et qui est en l'occurrence comprise entre 0,5mm et 0,8mm.

Un organe élastique s'étend depuis une zone centrale de la deuxième surface d'appui 45 du corps 43 du support de conformation 42.

L'organe élastique est un ressort 47. Le ressort 47 est fixé par une première extrémité à la deuxième surface d'appui 45. On note que l'organe élastique pourrait comporter plusieurs ressorts, et/ou une ou plusieurs lamelles élastiques, et/ou tout matériau souple tel que de la mousse.

La force de contre poussé du ressort 47 est choisie pour compenser exactement l'effort de pliage exercée par la portion flexible 48 au moment du conformage du circuit imprimé flexible 40.

La deuxième surface d'appui 45 du corps 43 du support de conformation 42, et la deuxième extrémité du ressort 47, sont destinées à venir en appui contre une surface complémentaire 49 du dissipateur thermique 41.

La surface complémentaire 49 est ici semblable à la surface complémentaire 26.

Le dissipateur thermique 41, et, notamment, le coin externe 50 et la surface complémentaire 49, sont fabriqués avec une tolérance de fabrication large, ici supérieure à 1mm.

Ainsi, au moment de la fixation du circuit imprimé flexible 40 sur le dissipateur thermique 41, le support de conformation 42 est fixé au coin externe 50 du dissipateur thermique 41 grâce à des moyens de fixation quelconques : vis, bouterollage, colle, encliquetage, etc.

Le ressort 47 permet d'assurer le contre appui et de compenser les tolérances de fabrication larges du dissipateur thermique 41 et du support de conformation 42.

On garantit ainsi à nouveau une conformation précise de la portion flexible 48 qui adopte une forme cylindrique. On assure à nouveau un éloignement d'au moins 1mm entre le dissipateur thermique 41 et chaque point de la portion flexible 48 par lequel passe un signal électrique à haute fréquence (ou tout autre signal électrique sensible).

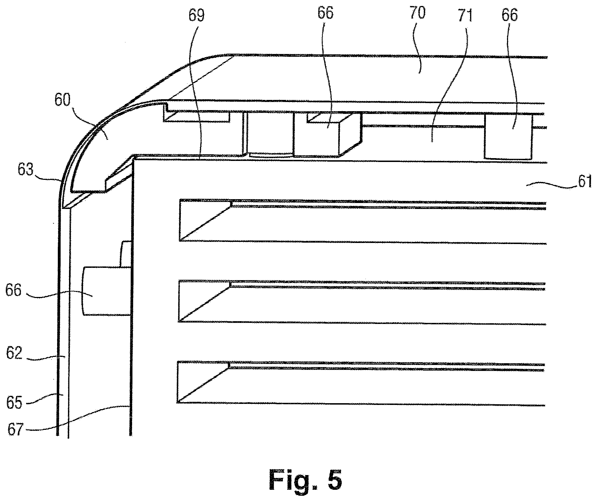

En référence à la figure 5, on note que le support de conformation 60, quel que soit son mode de réalisation, n'est pas nécessairement fixé au dissipateur thermique 61. Le support de conformation 60 peut aussi être fixé au circuit imprimé flexible 62, avant le pliage de la portion flexible 63, grâce à des moyens de fixation quelconques : vis, bouterollage, colle, encliquetage, etc.

Ainsi, au moment de la fixation du circuit imprimé flexible 62 sur le dissipateur thermique 61, on fixe tout d'abord le support de conformation 60 sur le circuit imprimé flexible 62.

La première portion 65 du circuit imprimé flexible 62 est ensuite fixée aux plots 66 de la première face latérale 67. Puis, la portion flexible 63 est conformée. A la fin du pliage, le support de conformation 60 vient en butée contre une surface complémentaire 69 du dissipateur thermique 61.

La deuxième portion 70 du circuit imprimé flexible 62 est alors fixée aux plots 66 de la deuxième face latérale 71.

Bien entendu, l'invention n'est pas limitée aux modes de réalisation décrits mais englobe toute variante entrant dans le champ de l'invention telle que définie par les revendications.

Bien que l'on ait cité certaines matières dans lesquelles peut être fabriqué le support de conformation, celui-ci peut parfaitement être fabriqué dans une matière différente.

On a décrit ici des circuits imprimés flexibles fixés chacun à un dissipateur thermique d'une passerelle résidentielle.

## Revendications

1. Dispositif comprenant :
- un circuit imprimé flexible (1 ; 20 ; 40 ; 62) comprenant au moins une portion flexible (5 ; 34 ; 48 ; 63) ;
- un dissipateur thermique (2 ; 21 ; 41 ; 61) ;
- un support de conformation (12 ; 22 ; 42 ; 60) de la portion flexible ;
le support de conformation étant positionné entre un coin externe (10 ; 30 ; 50) du dissipateur thermique (2 ; 21 ; 41 ; 61) et la portion flexible lorsque le circuit imprimé flexible est fixé sur le dissipateur thermique et que la portion flexible s'étend autour du coin externe du dissipateur thermique, le support de conformation comportant un corps (13 ; 23 ; 43) comprenant au moins une première surface d'appui (14 ; 24 ; 44) et au moins une deuxième surface d'appui (15 ; 25 ; 45), la première surface d'appui ayant la forme d'une portion angulaire de cylindre, la deuxième surface d'appui étant agencée pour venir en appui contre une surface complémentaire (17 ; 26 ; 49) du coin externe du dissipateur thermique, le support de conformation étant agencé pour assurer que la portion flexible du circuit imprimé flexible vient en appui contre la première surface d'appui lorsque le support de conformation est monté contre le dissipateur thermique et que le circuit imprimé flexible est fixé sur le dissipateur thermique, le circuit imprimé flexible comprenant en outre une première portion (3 ; 31 ; 65) fixée à une première face latérale (7 ; 27 ; 67) du dissipateur thermique et une deuxième portion (4 ; 36 ; 70) fixée à une deuxième face latérale (8 ; 28 ; 71) du dissipateur thermique.

2. Dispositif selon la revendication 1, dans lequel le corps (13 ; 23 ; 43) est fabriqué en une matière rigide avec une première tolérance de fabrication inférieure à un premier seuil de tolérance prédéterminé, le premier seuil de tolérance prédéterminé étant égal à 0,3mm.

3. Dispositif selon la revendication 2, dans lequel la surface complémentaire (17) est fabriquée par usinage avec une deuxième tolérance de fabrication inférieure à un deuxième seuil de tolérance prédéterminé, le deuxième seuil de tolérance prédéterminé étant égal à 0,1mm.

4. Dispositif selon l'une des revendications 2 ou 3, dans lequel le corps (13 ; 23 ; 43) comporte deux deuxièmes surfaces d'appui (15) pouvant venir en appui contre deux surfaces complémentaires (17) du dissipateur thermique, les deux surfaces complémentaires définissant le coin externe du dissipateur thermique (10).

5. Dispositif selon la revendication 1, dans lequel le corps (23) est fabriqué en une matière élastique.

6. Dispositif selon la revendication 5, dans lequel la matière élastique présente une dureté comprise entre 40 et 60 Shore A.

7. Dispositif selon l'une des revendications 5 ou 6, dans lequel les deux faces latérales (27 ; 28) se rejoignent au niveau de la surface complémentaire (26), les deux faces latérales et la surface complémentaire formant un angle cassé au niveau du coin externe (30).

8. Dispositif selon la revendication 1, dans lequel le corps (43) est fabriqué en une matière rigide, le support de conformation comportant en outre un organe élastique qui s'étend depuis la deuxième surface d'appui (45).

9. Dispositif selon la revendication 8, dans lequel l'organe élastique comporte au moins un ressort (47) et/ou une lamelle élastique.

10. Dispositif selon l'une des revendications précédentes, le support de conformation étant fixé au circuit imprimé flexible.

11. Dispositif selon l'une des revendications précédentes, dans lequel la portion flexible du circuit imprimé flexible est usinée localement pour permettre son pliage.

12. Equipement électrique comprenant un boîtier à l'intérieur duquel est intégré un dispositif selon l'une des revendications 1 à 11.

13. Equipement électrique selon la revendication 12, l'équipement électrique étant une passerelle résidentielle.

14. Procédé de fabrication d'un dispositif selon l'une des revendications 1 à 11, le support de conformation étant fixé au circuit imprimé flexible préalablement à la fixation du circuit imprimé flexible sur le dissipateur thermique.

## Patentansprüche

1. Vorrichtung, umfassend:
- eine flexible Leiterplatte (1; 20; 40; 62), die mindestens einen flexiblen Abschnitt (5; 34; 48; 63) umfasst;
- einen Kühlkörper (2; 21; 41; 61);
- einen Formgebungsträger (12; 22; 42; 60) zum Formen des flexiblen Abschnitts;
wobei der Formgebungsträger zwischen einer äußeren Ecke (10; 30; 50) des Kühlkörpers (2; 21; 41; 61) und dem flexiblen Abschnitt positioniert ist, wenn die flexible Leiterplatte an dem Kühlkörper befestigt ist und wenn sich der flexible Abschnitt um die äußere Ecke des Kühlkörpers erstreckt, wobei der Formgebungsträger einen Körper (13; 23; 43) umfasst, der mindestens eine erste Anlagefläche (14; 24; 44) und mindestens eine zweite Anlagefläche (15; 25; 45) umfasst, wobei die erste Anlagefläche die Form eines Winkelabschnitts eines Zylinders hat, wobei die zweite Anlagefläche ausgebildet ist, an einer komplementären Fläche (17; 26; 49) der äußeren Ecke des Kühlkörpers in Anlage zu kommen, wobei der Formgebungsträger ausgebildet ist, sicherzustellen, dass der flexible Abschnitt der flexiblen Leiterplatte an der ersten Anlagefläche zur Anlage kommt, wenn der Formgebungsträger an dem Kühlkörper angebracht ist und wenn die flexible Leiterplatte an dem Kühlkörper befestigt ist, wobei die flexible Leiterplatte ferner einen ersten Abschnitt (3; 31; 65) umfasst, der an einer ersten Seitenfläche (7; 27; 67) des Kühlkörpers befestigt ist, und einen zweiten Abschnitt (4; 36; 70), der an einer zweiten Seitenfläche (8; 28; 71) des Kühlkörpers befestigt ist.

2. Vorrichtung nach Anspruch 1, bei der der Körper (13; 23; 43) aus einem starren Material mit einer ersten Fertigungstoleranz hergestellt ist, die niedriger als ein erster vorbestimmter Toleranzschwellenwert ist, wobei der erste vorbestimmte Toleranzschwellenwert gleich 0,3 mm ist.

3. Vorrichtung nach Anspruch 2, bei der die komplementäre Fläche (17) durch maschinelle Bearbeitung mit einer zweiten Fertigungstoleranz hergestellt ist, die niedriger als ein zweiter vorbestimmter Toleranzschwellenwert ist, wobei der zweite vorbestimmte Toleranzschwellenwert gleich 0,1 mm ist.

4. Vorrichtung nach einem der Ansprüche 2 oder 3, bei der der Körper (13; 23; 43) zwei zweite Anlageflächen (15) umfasst, die an zwei komplementären Flächen (17) des Kühlkörpers in Anlage kommen können, wobei die beiden komplementären Flächen die äußere Ecke des Kühlkörpers (10) definieren.

5. Vorrichtung nach Anspruch 1, bei der der Körper (23) aus einem elastischen Material hergestellt ist.

6. Vorrichtung nach Anspruch 5, bei der das elastische Material eine Härte zwischen 40 und 60 Shore A aufweist.

7. Vorrichtung nach einem der Ansprüche 5 oder 6, bei der die beiden Seitenflächen (27; 28) im Bereich der komplementären Fläche (26) zusammenkommen, wobei die beiden Seitenflächen und die komplementäre Fläche eine gebrochene Kante im Bereich der äußeren Ecke (30) bilden.

8. Vorrichtung nach Anspruch 1, bei der der Körper (43) aus einem starren Material hergestellt ist, wobei der Formgebungsträger ferner ein elastisches Organ umfasst, das sich ab der zweiten Anlagefläche (45) erstreckt.

9. Vorrichtung nach Anspruch 8, bei der das elastische Organ mindestens eine Feder (47) und/oder ein Federblatt umfasst.

10. Vorrichtung nach einem der vorhergehenden Ansprüche, wobei der Formgebungsträger an der flexiblen Leiterplatte befestigt ist.

11. Vorrichtung nach einem der vorhergehenden Ansprüche, bei der der flexible Abschnitt der flexiblen Leiterplatte lokal bearbeitet wird, um seine Biegung zu gestatten.

12. Elektrisches Gerät, das ein Gehäuse umfasst, in dessen Innerem eine Vorrichtung nach einem der Ansprüche 1 bis 11 integriert ist.

13. Elektrisches Gerät nach Anspruch 12, wobei das elektrische Gerät ein Residential Gateway ist.

14. Verfahren zur Herstellung einer Vorrichtung nach einem der Ansprüche 1 bis 11, wobei der Formgebungsträger an der flexiblen Leiterplatte vor der Befestigung der flexiblen Leiterplatte an dem Kühlkörper befestigt wird.

## Claims

1. A device including:
- a flexible printed circuit (1; 20; 40; 62) comprising at least a flexible portion (5; 34; 48; 63);
- a heatsink (2; 21; 41; 61);
- a former (12; 22; 42; 60) of the flexible portion, the former being for positioning between the flexible portion and an outside corner (10; 30; 50) of the heatsink (2; 21; 41; 61) when the flexible printed circuit is fastened on the heatsink and the flexible portion extends around the outside corner of the heatsink, the former comprising a body (13; 23; 43) comprising at least one first bearing surface (14; 24; 44) and at least one second bearing surface (15; 25; 45), the first bearing surface having the shape of an angular portion of a cylinder, the second bearing surface being arranged to come to bear against a complementary surface (17; 26; 49) of the outside surface of the heatsink, the former being arranged to ensure that the flexible portion of the flexible printed circuit comes to bear against the first bearing surface when the former is mounted against the heatsink and the flexible printed circuit is fastened on the heatsink, the flexible printed circuit further comprising a first portion (3; 31; 65) fastened to a first side face (7; 27; 67) of the heatsink and a second portion (4; 36; 70) fastened to a second side face (8; 28; 71) of the heatsink.

2. A device according to claim 1, wherein the body (13; 23; 43) is made out of a rigid material and is manufactured to within a first manufacturing tolerance that is less than a first predetermined tolerance threshold, the first predetermined tolerance threshold being equal to 0,3mm.

3. A device according to claim 2, wherein the complementary surface (17) is machined with a second manufacturing tolerance of that is less than a second predetermined tolerance threshold, the second predetermined tolerance threshold being equal to 0,1mm.

4. A device according to claim 2 or claim 3, wherein the body (13; 23; 43) has two second bearing surfaces (15) suitable for coming to bear against two complementary surfaces (17) of the heatsink, the two complementary surfaces defining the outside corner of the heatsink (10).

5. A device according to claim 1, wherein the body (23) is made out of a resilient material.

6. A device according to claim 5, wherein the resilient material presents hardness lying in the range 40 to 60 on the Shore A scale.

7. A device according to claim 5 or claim 6, including a former according to claim 4, wherein the two side faces (27; 28) meet via the complementary surface (26), the two side faces and the complementary surface forming a broken angle at the outside corner (30).

8. A device according to claim 1, wherein the body (43) is made out of a rigid material, the former further including a resilient member that extends from the second bearing surface (45).

9. A device according to claim 8, wherein the resilient member comprises at least one spring (47) and/or spring blade.

10. A device according to any preceding claim, the former being fastened to the flexible printed circuit.

11. A device according to any preceding claim, wherein the flexible portion of the flexible printed circuit is machined locally in order to make it bendable.

12. Electrical equipment comprising a housing having integrated therein a device according to any one of claims 1 to 11.

13. Electrical equipment according to claim 12, the electrical equipment being a residential gateway.

14. Manufacturing process of a device according to any of claims 1 to 11, the former being fastened to the flexible printed circuit prior to fastening the flexible printed circuit on the heatsink.
